# EUROPEAN PATENT APPLICATION

(11) **EP 0 768 176 A1**
(43) Date of publication of application: **16.04.1997**
(21) Application number: 96307188.1
(22) Date of filing: 01.10.1996
(51) Int. Cl.: B41F 15/40

(54) **System and method for high resolution screen printing**

(30) Priority: 10.10.1995 US 541535
(71) Applicant: Lucent Technologies Inc., Murray Hill, New Jersey 07974-0636 (US)
(72) Inventor: James, Edward John, Salisbury, North Carolina 28146 (US)
(74) Representative: Johnston, Kenneth Graham

(57) **Abstract**

Embodiments of the invention include a high resolution screen printing system and method that controllably dispenses printing fluid over the surface of the printing screen (62) by combining a controlled print head (52) together with dispenser (82) such as one or more pneumatic cartridges (84). The dispenser is mounted adjacent to the squeegee (76) and dispenses print fluid such as dielectric pastes that reaches the screen as the squeegee is print traveling thereacross. In this manner, the invention maintains consistent yet minimal paste volume that reaches the screen (62) during printing without stopping to add paste, and eliminates the use of a flood blade and any screen flooding procedures. Thus, the disclosed screen printing system significantly improves thickness uniformity of the final product while reducing the need for screen wiping thereby saving time and manufacturing resources.

## Description

### Background of the Invention

### 1. Field of the Invention

The invention relates to high resolution screen printing. More particularly, the invention relates to an improved system and method for high resolution screen printing having a dispenser for controllably dispensing print fluid that reaches the printing screen.

### 2. Description of the Related Art

High resolution printing of large areas, e.g., in manufacturing circuit boards such as format E thick film Multilayer Interconnect Boards (MIBs), is severely complicated by problems associated with the application of print fluids (e.g., dielectric and conductive pastes). Generally, in screen printing of this kind, a mesh screen having a stenciled or patterned underside is operably positioned on or with respect to a substrate, a print fluid is deposited and spread over the screen using a flood blade, a squeegee is passed over the screen to print the pattern on the substrate, and then the screen is peeled from the substrate, hopefully leaving behind a uniform, patterned layer of paste on designated portions of the substrate. In this same manner, subsequent layers are printed on the substrate to complete one of many board levels.

However, it is difficult to achieve consistent thickness uniformity from one printing to the next and in maintaining high line resolution across each board level and high via resolution between board levels, especially when printing large format boards, e.g., SEM E boards, with high tack paste. If the flood blade does not spread the print fluid completely and uniformly over the screen, uniform thickness of the final printed pattern is unlikely. Also, if the amount of paste on the screen just ahead of the moving squeegee becomes excessive (as is the tendency), the resulting print is such that the screen will not peel out of the printed layer on the substrate and will cause the printed paste to deform and smear. Thus, line resolution is diminished and via resolution of the screen is diminished for subsequent printing.

Typically, the immediate solution to these problems has been to clean the screen frequently, sometimes as often as after printing each board layer. However, such cleaning frequency severely reduces the print defining or gasketing quality of the screen (i.e., the ability of the screen to allow print fluid to pass through during printing) and the screen life (due to stretching), in addition to being costly, time consuming and generally a waste of manufacturing resources.

In attempting to solve the problem, there has been a focus on factors such as screen size and paste composition requirements. Also, improvements in emulsion gasketing have been studied, as well as bringing increased hydraulic pressure closer to the squeegee.

It has been reported that moving the point of maximum hydraulic pressure closer to the squeegee tip improves via and line resolution of the printed pattern. Also, improved printing conditions necessary to achieve better resolution were determined to include high print (squeegee) speed, the use of high mesh count fine wire screens and minimal paste volume in front of the squeegee during operation. However, minimal paste volume on the screen in front of the squeegee requires the addition of paste after every few prints, which is labor intensive, time consuming and generally inefficient. Therefore, despite general recognition of some of the problems associated with high resolution screen printing, a satisfactory solution has yet to be established.

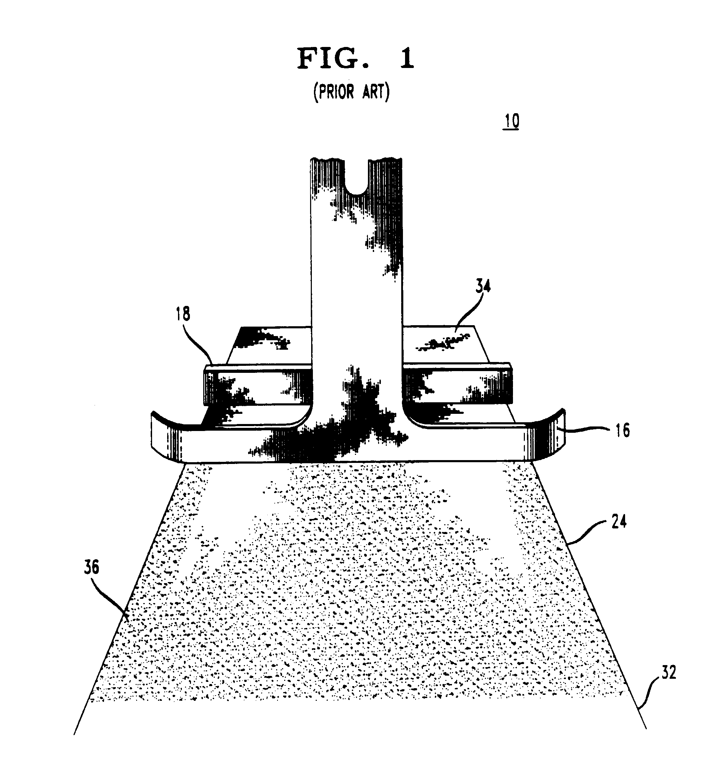

FIG. 1 depicts portions of a conventional high resolution screen printer 10. In general, screen printer 10 has a print head (not shown) having operably attached thereto a flood blade 16 and a squeegee 18. Movement of the print head, and consequently movement of flood blade 16 and squeegee 18, is controlled by a controller (not shown), which is typically microprocessor-based. A tool plate (not shown) receives a substrate to be printed on and positions it a distance (known as the snap-off distance) under an installed screen 24, which contains a pattern for printing appropriate areas of the substrate.

In conventional screen printing operation, screen 24 is installed and critical alignment and print parameter adjustments known in the art are made. Then, with the print head positioned near a first end 32 of screen 24, a volume of print fluid such as dielectric paste is applied to screen 24 near first end 32 but between squeegee 18 and a second end 34 of screen 24. At this stage of the printing operation, squeegee 18 is positioned slightly off of screen 24.

The controller then moves the print head laterally toward second end 34 of screen 24 so that flood blade 16 passes over screen 24 thereby flooding screen 24 with paste (shown generally as 36). In conventional screen printing operation, paste 36 generally does not flood or spread uniformly over screen 24, as shown, thus causing excessive paste in some areas and insufficient amounts of paste in other areas.

After screen 24 has been flooded with paste 36, the print head, now positioned near second end 34 of screen 24, raises flood blade 16 off of screen 24, lowers squeegee 18 until it makes operable contact with screen 24, and begins moving squeegee 18 laterally across screen 24 to its first end 32. As squeegee 18 moves across screen 24, squeegee 18 presses screen 24 onto the substrate therebelow, thereby printing the preselected pattern of screen 24 onto the substrate. Upon completion of printing, screen 24 is peeled off of the substrate and the tool plate retracts to its original position. The substrate is removed, replaced with another substrate to be printed, and the process is repeated.

Typically, in conventional screen printing, operation of screen printer 10 is discontinued after an average of three prints so that screen 24 can be washed and dried, which collectively requires approximately 3 minutes. In the manufacture of MIBs, this translates into approximately 12 hours of down time per lot of 40 MIBs, assuming 6 dielectric levels per board that each have to be printed 3 times (i.e., 40 washings x 3 minutes per wash x 6 levels). Thus, assuming 3 to 4 lots of MIBs are shipped per week, approximately 36 to 48 hours of manufacturing down time is attributable to the problems associated with this conventional method of screen printing.

### Summary of the Invention

The invention is as defined by the claims. According to its major aspects and broadly stated, embodiments of the invention include a high resolution screen printing system and method having a controlled print head together with a dispenser such as at least one pneumatic cartridge to controllably dispense print fluid over the surface of the printing screen. The dispenser is mounted adjacent to the squeegee and dispenses print fluid such as dielectric pastes that reaches the screen as the squeegee is print traveling thereacross. In this manner, the invention maintains consistent yet minimal paste volume that reaches the screen during printing without stopping to add paste, and eliminates the use of a flood blade and any screen flooding procedures. Thus, the disclosed screen printing system significantly improves thickness uniformity of the final product while reducing the need for screen wiping thereby saving time and manufacturing resources.

### Brief Description of the Drawings

FIG. 1 is a partial perspective view of a conventional high resolution screen printing system;
FIG. 2 is a partial perspective view and schematic diagram of a high resolution screen printing system according to the invention; and
FIG. 3 is a partial perspective view of the high resolution screen printing system of FIG. 2, showing the squeegee and one of the pneumatic dispensers.

### Detailed Description

In the following description similar components are referred to by the same reference numeral in order to simplify the drawings.

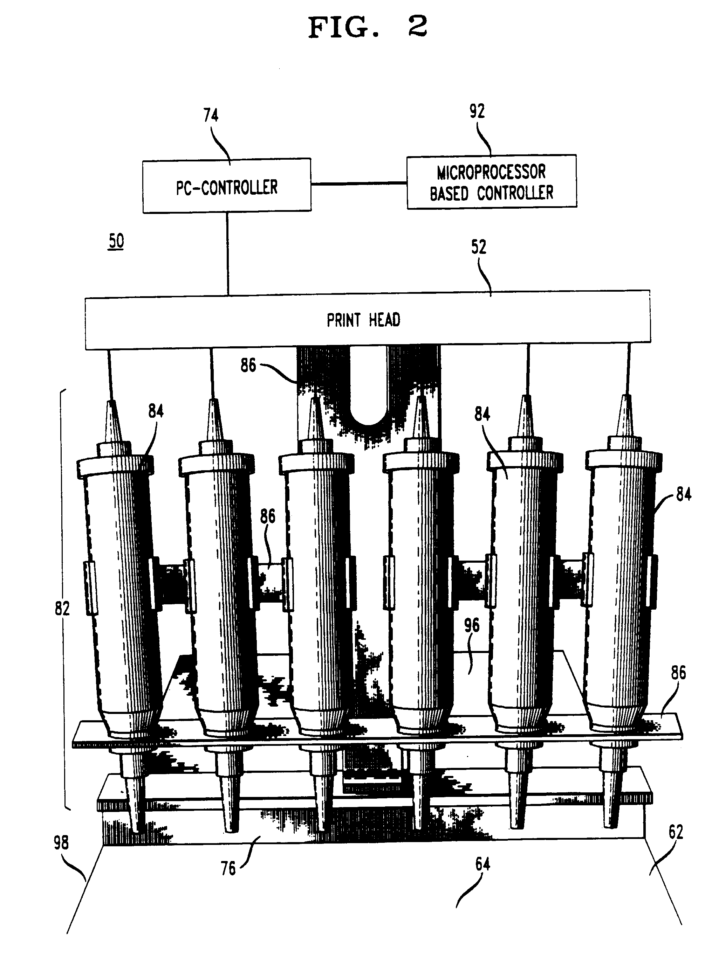

Referring now to FIGs. 2-3, a screen printing system 50 according to the invention is shown. Screen printer 50 has a print head (shown schematically as 52) that moves laterally over a screen surface 62 having a primary side 64. A tool plate (not shown) receives and operably positions a substrate (not shown) with respect to a secondary side (not shown) of screen printing surface 62 opposite primary side 64. Operably connected to print head 52 is a squeegee 76 for passing laterally over primary side 64 of screen printing surface 62 to print its pattern on the substrate. Movement of print head 52 is controlled by a controller (shown schematically as 74), which can be any suitable controller such as a PC- or microprocessor-based controller.

Instead of using a flood blade (e.g., flood blade 16 shown in FIG. 1), screen printing system 50 according to the invention has operably connected to print head 52 a print fluid dispenser (shown generally as 82), such as one or more refillable, pneumatic cartridges 84. Cartridges 84 are connected to print head 52 by any suitable connector, such as a cartridge holder 86, and oriented so that cartridges 84 dispense print fluid that reaches screen 24 down to approximately 1/8 inch in front of squeegee 76 as squeegee 76 is print traveling thereacross.

The dispensing operation of dispenser 82 is controlled by controller 74. Alternatively, a second controller 92 is slaved to controller 74 so that the movement of print head 52 and the dispensing operation of dispenser 82 are individual controlled but coordinated appropriately. Such coordination will be discussed in greater detail below.

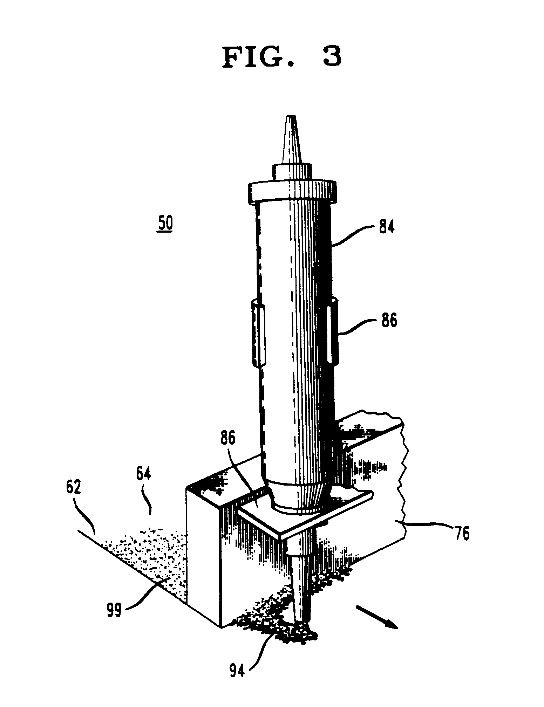

Controller 92 is configured so that dispenser 82 dispenses an initial amount of print fluid that reaches primary side 64 of screen printing surface 62 just prior to the beginning of the print stroke of squeegee 76, i.e., just prior to the start of squeegee 76 moving laterally screen printing surface 62. Controller 92 is also configured to allow additional print fluid (shown as 94 in FIG. 3) to be added (continuously or periodically) to screen printing surface 62 just in front of squeegee 76 during the print cycle, i.e., as squeegee 76 is moving laterally across screen printing surface 62. Alternatively, controller 92 is configured to delay the start of the print stroke of squeegee 76 until after dispenser 82 has completed dispensing an initial amount of print fluid 94.

Controller 92 is configured to permit adjustments for the duration and pressure of print fluid 94 being dispensed from cartridges 84. These adjustments, when combined with choosing nozzles having the appropriate orifice size for cartridges 84, allow very precise control of the volume of print fluid 94 dispensed prior to and during each print cycle. Furthermore, altering these adjustments accordingly allows screen printing system 50 to accommodate most any size print area with most any print fluid viscosity. Establishing the appropriate nozzle size and controller adjustments depends on the particular screen printing application, but can be determined with a modicum of experimentation by one skilled in the art.

In making use of the advantageous components of screen printing system 50 according to the invention, a more practical screen printing method is used to produce results superior to conventional screen printing methods. According to the invention, screen printing surface 62 is installed initially and known critical alignment and print parameter adjustments are made. Then, the substrate of interest is operably positioned with respect to a secondary side of screen printing surface 62 opposite primary side 64.

Prior to the actual screen printing operation, print head 52 positions squeegee 76 and cartridges 84 near an end 96 of screen printing surface 62. Then, print head 52 causes squeegee 76 to be lowered so that squeegee 76 makes contact with primary side 64 of screen printing surface 62 to initiate the print stroke of squeegee 76 and the initial, controlled dispensing of print fluid 94 by cartridges 84. If controller 92 is configured to delay the start of the print stroke of squeegee 76, as discussed above, print head 52 does not begin moving dispenser 82 and squeegee 76 laterally across screen printing surface 62 until the dispensing time delay has occurred and a desired volume of print fluid 94 has been dispensed.

As print head 52 moves squeegee 76 toward an end 98 of screen printing surface 62, squeegee 76 temporarily compresses a portion of screen printing surface 62 onto the substrate thereby printing the appropriate pattern (shown generally as 99) on the substrate. As stated previously, additional print fluid 94 is added to screen printing surface 62 during the print cycle, i.e., as print head 52 moves squeegee 76 laterally across screen printing surface 62.

Thus, in operation, screen printing system 50 dispenses a predetermined volume of print fluid 94 that reaches screen printing surface 62 at the beginning of the print cycle and, if necessary, adds additional print fluid 94 during the print cycle without interrupting the overall printing process. In this manner, the volume of print fluid 94 for a given printing cycle is controlled sufficiently to pattern a single substrate uniformly, yet leave screen printing surface 62 and squeegee 76 sufficiently wetted with print fluid for printing the next substrate.

Using the high resolution screen printing according to the invention and described herein results in significant improvement in via resolution between printed board levels, improved thickness uniformity and increased throughput. Also, it reduces material waste and labor costs, minimizes on-screen drying of print fluid and eliminates the possibility of paste viscosity changes due to exposure to the environment.

### Example

A pneumatic dispensing system, manufactured by EFD, Inc. was installed on a standard AMI model 1505 thick film screen printer. The flood blade was replaced by a custom designed cartridge holder with a capacity for up to six 30 cc or 55 cc dispensing cartridges. Six dispensing cartridges were mounted in the cartridge holders in a manner that allows print fluid, specifically dielectric paste, to be applied to the screen just in front of the squeegee. Two pneumatic controllers were installed with 1:3 air manifolds so that each controller fed three dispensing cartridges. In this particular example, controller #1 fed dispensing cartridges 1, 3 and 5, and controller #2 fed dispensing cartridges 2, 4 and 6 to yield a more uniform distribution of paste. The nozzle orifice of each dispensing cartridge and the air pressure was adjusted so that the volume of paste dispensed was approximately 105% (approximately 2 grams) of the volume needed to print a single board and so that the paste was dispensed as close to the forward moving edge of the squeegee. Also, the dispensing time was adjusted for the proper print cycle.

A signal for the squeegee to drop onto the screen was used to initiate the dispensing cycle just prior to the squeegee forward print stroke. As print speed was increased to yield increased print thickness, it was found that the dispensing system could not deposit the paste fast enough to preclude voids in the printed layer. It was determined that a forward stroke delay of approximately 1-10 seconds was needed to allow sufficient paste to be deposited prior to initiation of each print stroke.

As a result, new 486 PC-based print controllers were installed to replace the original AMI process controllers. The new 486 PC-based print controllers allowed for a programmable squeegee travel delay time. As a result, the modified 1505 printers equipped with the pneumatic dispensers are capable of printing at squeegee speeds up to 3 inches per second with full dispensing capability over the entire speed range.

**TABLE I**

| PRINT PROCESS COMPARISON | | |
|---|---|---|
| | PRIOR ART | INVENTION |
| Screen | 200 mesh | 200 mesh |
| | 38 cm x 38 cm | 38 cm x 38 cm |
| Emulsion | 12.5 µm | 12.5 µm |
| Snap Off | 2.5 mm | 1.8 mm |
| Squeegee | 80 durometer | 80 durometer |
| | 45° angle | 45° angle |
| Speed | 15 mm/sec | 75 mm/sec |

**TABLE II**

| RESULTS COMPARISON | | |
|---|---|---|
| | PRIOR ART | INVENTION |
| Via Taper | 300 - 450 µm | 300 - 350 µm |
| Resolution | ±125 µm | ±12.5 µm |
| Washings/100 prints | 25-50 | 0 |

As described in the foregoing example and shown in the accompanying tables, the invention allows an equally large print area to be printed, using an equally high tack paste, but at a greater squeegee speed and a lower snap off distance, as shown in Table I. Also, as shown in Table II, via resolution has improved in that via taper is reduced from nearly 50% of via size from top to bottom to approximately 20% and via size is within 12 µm across the entire substrate. Finally, the need to wash screens has been eliminated as a routine operation and savings therefrom amounts to approximately 50% of printer touch labor per week.

Although the results of the foregoing example are highly favorable, they are not intended to limit the scope of the invention. Theoretically, the squeegee speed is limited only by the physical and mechanical limits of the equipment being used. Furthermore, the foregoing experiment was conducted using a relatively large printing area and a relatively high tack paste, both of which make it more difficult to achieve satisfactory results.

It will be apparent to those skilled in the art that many changes and substitutions can be made to the high resolution screen printing system herein described without departing from the spirit and scope of the invention as defined by the appended claims.

## Claims

1. Apparatus for screen printing, said apparatus for use with a substrate having a surface, said apparatus comprising:
a patterned screen having a first end and a second end, said patterned screen having a tool plate for receiving and positioning said substrate in such a way that said substrate surface is positioned for printing thereon from said patterned screen;
a print head operably positioned with respect to said patterned screen;
a squeegee operably connected to said print head and positioned for compressing said patterned screen onto said substrate surface;
a dispenser operably connected to said print head and positioned adjacent to said squeegee, said dispenser capable of dispensing a print fluid onto said patterned screen;
said print head being capable of moving said squeegee across said patterned screen between said first and said second ends to print said print fluid on said substrate surface through said patterned screen; and
a controller in operable connection with said print head and said dispenser that controls the movement of said print head across said patterned screen, controls the dispensing of print fluid from said dispenser and coordinates the movement of said print head with the dispensing of print fluid by said dispenser.

2. The apparatus as recited in claim 1, wherein said dispenser further comprises a pneumatic fluid dispenser and said controller controls the frequency and volume of said print fluid dispensed by said pneumatic fluid dispenser.

3. The apparatus as recited in claim 1, wherein said dispenser further comprises one or more pneumatic cartridges.

4. The apparatus as recited in claim 1, wherein at least one of said first and said second controllers further comprises a microprocessor-based controller.

5. A method for screen printing, said method for use with a substrate, said method comprising the steps of:
providing a screen printer having a patterned screen and a print head with a squeegee and a fluid dispenser operably connected thereto, said patterned screen having a forward end and an opposing rear end;
operably positioning said substrate with respect to a said patterned screen;
positioning said print head so that said squeegee and said fluid dispenser are operably positioned at said rear end of said patterned screen;
controllably moving said print head to pass said squeegee operably over said patterned screen from said rear end to said forward end in such a way that said squeegee compresses said patterned screen onto said substrate; and
controllably dispensing said print fluid on said patterned screen between said squeegee and said forward end of said patterned screen in such a way that the pattern is printed onto said substrate when said squeegee compresses said patterned onto said substrate,
wherein said moving and dispensing steps are controlled and coordinated with one another by a controller operably connected thereto.

6. The apparatus as recited in claim 5, further comprising the step of dispensing said print fluid that reaches said patterned screen between said squeegee and said forward end as said squeegee is moving toward said forward end.

7. The apparatus as recited in claim 5, further comprising the step of initiating a dispensing time interval whereby, prior to said moving step, said dispenser dispenses an initial volume of said print fluid that reaches said rear end of said patterned screen between said squeegee and said forward end of said patterned screen.

8. The apparatus as recited in claim 5, wherein said dispensing step further comprises controlling the duration and pressure of said print fluid being dispensed.

9. The apparatus as recited in claim 5, wherein said dispensing step dispenses said print fluid approximately 1/8 inch from said squeegee.
